# EUROPEAN PATENT APPLICATION

(11) **EP 4 376 071 A1**
(43) Date of publication of application: **29.05.2024**
(21) Application number: 21953115.9
(22) Date of filing: 11.08.2021
(51) Int. Cl.: H01L 23/485, H01L 23/522, H01L 23/538

(54) **CHIP PACKAGING STRUCTURE AND PREPARATION METHOD FOR CHIP PACKAGING STRUCTURE**

(71) Applicant: Huawei Technologies Co., Ltd., Shenzhen, Guangdong 518129 (CN)
(72) Inventor: HE, Ran, Shenzhen, Guangdong 518129 (CN); JIAO, Huifang, Shenzhen, Guangdong 518129 (CN)
(74) Representative: Gill Jennings & Every LLP
(86) International application number: PCT/CN2021/112096
(87) International publication number: WO 2023/015492

(57) **Abstract**

Embodiments of this application provide a chip package structure and a preparation method. The chip package structure includes a first chip and a first hybrid bonding structure. The first chip is connected to another chip through the first hybrid bonding structure. The first hybrid bonding structure includes a first bonding layer. The first bonding layer is disposed on a side away from a substrate of the first chip, and the first bonding layer includes a first insulation material and a plurality of first metal solder pads embedded in the first insulation material. Each of the plurality of first metal solder pads includes a groove structure. A groove bottom of the groove structure is buried in the first insulation material, and a groove opening of the groove structure is exposed to a surface of the first insulation material and is flush with the surface of the first insulation material. The groove structure is filled with a first insulation medium, and a surface of the first insulation medium is flush with the surface of the first insulation material. The chip package structure may improve performance of signal transmission between packaged chips.

## Description

### TECHNICAL FIELD

Embodiments of this application relate to the field of semiconductor packaging technologies, and in particular, to a chip package structure and a method for preparing a chip package structure.

### BACKGROUND

With the development of semiconductor technologies, electronic devices are developed to be lighter, thinner, and shorter, with more performance and features integrated into smaller space. Therefore, a chip packaging technology gains more importance in an electronic device industry chain. A 3-dimensional integrated circuit (3D IC, 3-dimensional integrated circuit) packaging technology can greatly improve packaging integration density and reduce a packaging size, and currently becomes a mainstream packaging technology.

Currently, in the 3D IC packaging technology, a plurality of chips (or wafers) are generally stacked through a hybrid bonding process. In the hybrid bonding process, planarization processing generally needs to be performed on a surface of a bonding region of a chip through a polishing process, and then alignment bonding is separately performed on metal materials and insulation materials of bonding regions of two chips in an insulation material-insulation material bonding and metal material-metal material bonding manner. Because polishing rates of the metal material and the insulation material are different, in a bonding interface, a surface of the metal material is slightly lower than a surface of the insulation material. Consequently, a surface of the chip or the wafer is not flat. In addition, a larger area of a metal pattern in the bonding interface indicates a larger height difference between the surface of the metal material surface and the surface of the insulation material. The height difference reduces a fitting degree between to-be-bonded chips, and consequently affects performance of signal transmission between a plurality of packaged chips. Therefore, in the 3D IC packaging technology, how to improve the performance of the signal transmission between the plurality of packaged chips becomes a problem that needs to be resolved.

### SUMMARY

According to a chip package structure and a method for preparing a chip package structure provided in this application, performance of signal transmission between packaged chips can be improved.

To achieve the foregoing objective, this application uses the following technical solutions.

According to a first aspect, an embodiment of this application provides a chip package structure. The chip package structure includes a first chip and a first hybrid bonding structure. The first chip is connected to another chip through the first hybrid bonding structure. The first hybrid bonding structure includes a first bonding layer. The first bonding layer is disposed on a side away from a substrate of the first chip, and the first bonding layer includes a first insulation material and a plurality of first metal solder pads embedded in the first insulation material. Each of the plurality of first metal solder pads includes a groove structure. A groove bottom of the groove structure is buried in the first insulation material, and a groove opening of the groove structure is exposed to a surface of the first insulation material and is flush with the surface of the first insulation material. The groove structure is filled with a first insulation medium, and a surface of the first insulation medium is flush with the surface of the first insulation material.

In this embodiment of this application, a surface of the first metal solder pad, the surface of the first insulation material, and the surface of the first insulation medium are flush, so that a bonding interface of the first bonding layer tends to be flat. This avoids inward depression of the surface of the first metal solder pad, and avoids a hole on the bonding interface when the first bonding layer and another bonding layer are bonded. This helps increase a contact area between the metal solder pads on which alignment bonding is performed, improves a bonding effect, and improves performance of signal transmission between the first chip and another chip.

Based on the first aspect, in a possible implementation, a plurality of vias are further disposed in the first bonding layer; each of the plurality of vias is filled with or electroplated with a conductive material; and at least a part of the plurality of first metal solder pads are connected to the first chip through a corresponding via.

Based on the first aspect, in a possible implementation, the first hybrid bonding structure further includes a first redistribution layer. The first redistribution layer is formed between the first chip and the bonding layer, and the first redistribution layer includes a plurality of layers of patterned conductive lines. The at least a part of the plurality of first metal solder pads are connected to the first chip through the plurality of vias and the conductive lines.

Based on the first aspect, in a possible implementation, a pattern formed on a surface of each of the plurality of first metal solder pads is a ring.

Based on the first aspect, in a possible implementation, the chip package structure further includes a second chip and a second hybrid bonding structure. The second chip is stacked above the first chip, and the second chip is connected to the first chip through the first hybrid bonding structure and the second hybrid bonding structure.

Based on the first aspect, in a possible implementation, the second hybrid bonding structure includes a second bonding layer. The second bonding layer is disposed on a side away from a substrate of the second chip, and the second bonding layer includes a second insulation material and a plurality of second metal solder pads embedded in the second insulation material. Each of the plurality of second metal solder pads includes the groove structure. A groove bottom of the groove structure is buried in the second insulation material, and a groove opening of the groove structure is exposed to a surface of the second insulation material and is flush with the surface of the second insulation material. The groove structure is filled with a second insulation medium, and a surface of the second insulation medium is flush with the surface of the second insulation material.

Based on the first aspect, in a possible implementation, the first metal solder pads are configured to be correspondingly bonded to the second metal solder pads, the first insulation material is configured to be correspondingly bonded to the second insulation material, and the first insulation medium is configured to be correspondingly bonded to the second insulation medium.

Based on the first aspect, in a possible implementation, a pattern formed on a surface of each of the plurality of second metal solder pads is a ring.

According to the chip package structure provided in this embodiment of this application, the patterns of the surfaces of the first metal solder pad and the second metal solder pad are set to be the ring, so that when the first metal solder pad and the second metal solder pad are bonded, regardless of how a relative position between the surface of the first metal solder pad and the surface of the second metal solder pad is offset, a large overlapping area exists between the surface of the first metal solder pad and the surface of the second metal solder pad. Therefore, in this embodiment of this application, a pattern of a to-be-bonded surface of a metal solder pad is set to be a ring, so that a bonding area between the surface of the first metal solder pad and the surface of the second metal solder pad can be increased when depths of depression of the surface of the first metal solder pad and the surface of the second metal solder pad into a bonding layer is reduced. This improves performance of signal transmission between packaged chips.

According to a second aspect, an embodiment of this application provides an electronic device, where the electronic device includes the chip package structure according to the first aspect.

A chip packaged in the chip package structure may include but is not limited to: a system-on-a-chip (system-on-a-chip), a memory (Memory), a discrete device, an application processor (Application Processor, AP) chip, a micro-electro-mechanical system (Micro-Electro-Mechanical System, MEMS), a microwave radio frequency chip, an application-specific integrated circuit (Application-Specific Integrated Circuit, ASIC for short), and the like. During specific application, the application processor chip or the application-specific integrated circuit may be a central processing unit (Central Processing Unit, CPU), a graphics processing unit (Graphics Processing Unit, GPU), or an artificial intelligence processor, for example, a neural-network processing unit (Neural-Network Processing Unit, NPU). The memory may be a cache (cache), a random access memory (Random Access Memory, RAM), a read-only memory (Read-Only Memory, ROM), or another memory. The discrete device may include, for example, but is not limited to, a field-effect transistor, a bipolar transistor, and an integrated operational amplifier. Alternatively, the electronic device may be an integrated circuit product. In addition to the chip package structure described in this embodiment of this application, the integrated circuit product may further include another integrated circuit, so that the chip package structure shown in this embodiment of this application cooperates with the another integrated circuit to implement various circuit functions.

According to a third aspect, an embodiment of this application provides a method for preparing a chip package structure. The preparation method includes: forming a first insulation material on an active surface of a first chip; etching the first insulation material to form a plurality of grooves; depositing a metal material on a surface of the first insulation material, where the metal material forms a groove structure in the grooves; depositing a first insulation medium on a surface of the metal material; and performing planarization processing on the first insulation medium, the metal material, and the first insulation material through a polishing process, to form a first bonding layer. The first bonding layer includes a plurality of first metal solder pads, each the plurality of first metal solder pads includes the groove structure. A groove opening of the groove structure is exposed to the surface of the first insulation material and is flush with the surface of the first insulation material, and a surface of the first insulation medium is flush with the surface of the insulation material.

Based on the third aspect, in a possible implementation, the forming a first insulation material on an active surface of the first chip includes: forming a redistribution layer on the active surface of the first chip, where the redistribution layer includes a plurality of layers of patterned conductive lines; and forming the first insulation material on the redistribution layer.

Based on the third aspect, in a possible implementation, after the etching the first insulation material to form a plurality of grooves, the method further includes: further etching a bottom of at least a part of the plurality of grooves, to form a via that connects the bottom of the groove and the conductive line on the redistribution layer.

Based on the third aspect, in a possible implementation, the method further includes: forming a second bonding layer on an active surface of a second chip. The second bonding layer includes a second insulation material and a plurality of second metal solder pads embedded in the second insulation material. Each of the plurality of second metal solder pads includes a groove structure. A groove bottom of the groove structure is buried in the second insulation material, and a groove opening of the groove structure is exposed to a surface of the second insulation material and is flush with the surface of the second insulation material. The groove structure is filled with a second insulation medium, and a surface of the second insulation medium is flush with the surface of the second insulation material.

Based on the third aspect, in a possible implementation, the method further includes: bonding the plurality of first metal solder pads to the plurality of second metal solder pads, the first insulation material to the second insulation material, and the first insulation medium to the second insulation medium through a same bonding process.

### BRIEF DESCRIPTION OF DRAWINGS

To describe technical solutions in embodiments of this application more clearly, the following briefly describes the accompanying drawings for describing embodiments of this application. It is clear that the accompanying drawings in the following descriptions show merely some embodiments of this application, and persons of ordinary skill in the art may still derive other drawings from these accompanying drawings without creative efforts.
FIG. 1A is a schematic diagram of a 3D IC package structure in a conventional technology according to an embodiment of this application;
FIG. 1B is a top view of a bonding interface of the 3D IC package structure shown in FIG. 1A;
FIG. 1C is a side view comparison diagram of depths of inward depression of metal solder pads with different surface areas according to an embodiment of this application;
FIG. 1D is a top view comparison diagram of patterns formed on bonding interfaces by metal solder pads with different surface areas according to an embodiment of this application;
FIG. 2 is a schematic structural diagram of a chip package structure according to an embodiment of this application;
FIG. 3 is a schematic diagram of a relative position relationship between a chip and a hybrid bonding structure before chip packaging according to an embodiment of this application;
FIG. 4 is a top view of a hybrid bonding structure according to an embodiment of this application;
FIG. 5 is a side view of the hybrid bonding structure in FIG. 4 cut along AA' according to an embodiment of this application;
FIG. 6 is a schematic structural diagram of a chip package structure formed through packaging by using the hybrid bonding structure shown in FIG. 4 according to an embodiment of this application;
FIG. 7 is a schematic diagram of a chip package structure in which a relative position between surfaces of two metal solder pads used for bonding is offset according to an embodiment of this application;
FIG. 8 is a top view of a bonding interface of the chip package structure shown in FIG. 7 according to an embodiment of this application;
FIG. 9 is still another top view of a bonding interface of a chip package structure in which a relative position between surfaces of two metal solder pads used for bonding is offset according to an embodiment of this application;
FIG. 10 is still another top view of a bonding interface of a chip package structure in which a relative position between surfaces of two metal solder pads used for bonding is offset according to an embodiment of this application;
FIG. 11 is still another schematic structural diagram of a hybrid bonding structure according to an embodiment of this application;
FIG. 12 is a schematic structural diagram of a chip package structure formed through packaging by using the hybrid bonding structure shown in FIG. 11 according to an embodiment of this application;
FIG. 13 is a flowchart of a method for preparing the chip package structure shown in FIG. 1 according to an embodiment of this application; and
FIG. 14A to FIG. 14F are schematic structural diagrams in a process of preparing the chip package structure shown in FIG. 13.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by persons of ordinary skill in the art based on embodiments of this application without creative efforts shall fall within the protection scope of this application.

The term "first", "second", or the like mentioned in this specification does not indicate any order, quantity, or importance, but is used only for distinguishing between different components. Likewise, the term "alan", "one", or the like is not intended to indicate a quantity limitation either, but is intended to indicate at least one.

In embodiments of this application, a word such as "example" or "for example" is used to represent an example, an illustration, or a description. Any embodiment or design scheme described as an "example" or "for example" in embodiments of this application should not be explained as being more preferred or having more advantages than another embodiment or design scheme. To be precise, the word such as "example" or "for example" is intended to present a related concept in a specific manner. In the descriptions of embodiments of this application, unless otherwise stated, "a plurality of" means two or more than two. For example, a plurality of chips are two or more chips.

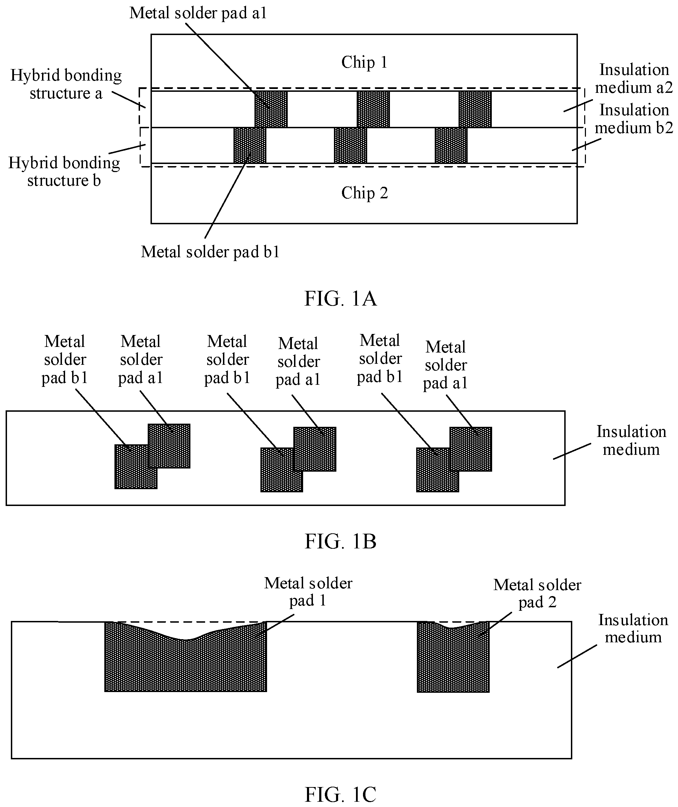

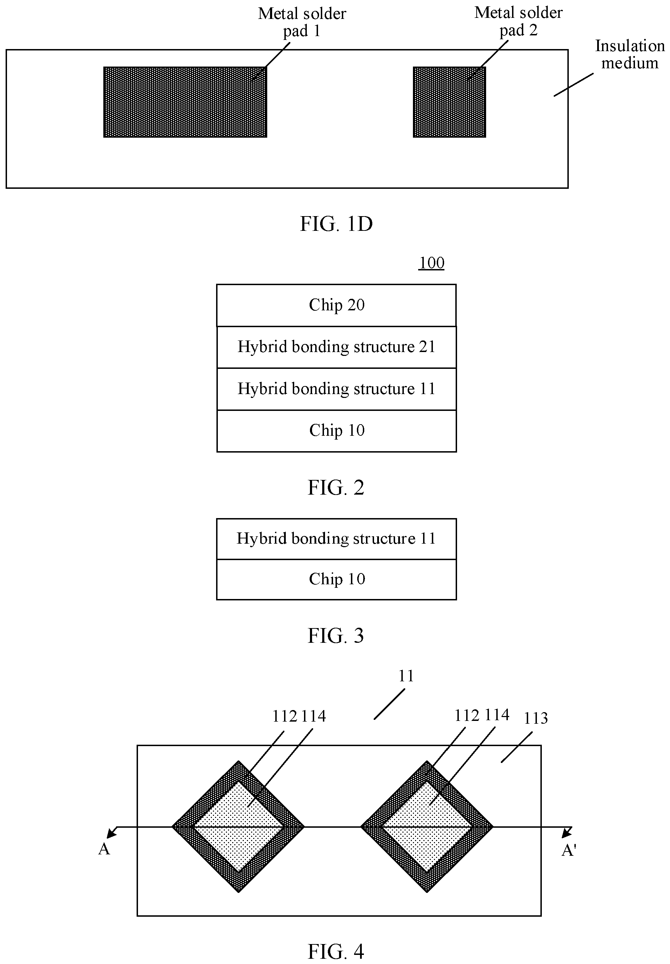

FIG. 1A is a schematic diagram of a conventional 3D IC package structure, and FIG. 1B is a top view of a bonding interface of the 3D IC package structure shown in FIG. 1A. In FIG. 1A, to stack the chip 1 on the chip 2, a bonding structure a {a metal solder pad a1, and an insulation medium a2} and a bonding structure b {a metal solder pad b1, and an insulation medium b2} generally need to be disposed. Then, a bonding interface (bonding interface) that includes the metal solder pad a1 and the insulation medium a2 and that is in the bonding structure a is bonded to a bonding interface that includes the metal solder pad b1 and the insulation medium b2 and that is in the bonding structure b. In a bonding process, alignment bonding is performed on the metal solder pad a1 and the metal solder pad b1 and on the insulation medium b1 and the insulation medium b2. The bonding interface of the bonding structure a and the bonding interface of the bonding structure b are separately obtained by polishing surfaces of a hybrid bonding structure a and a hybrid bonding structure b through a chemical mechanical polishing (CMP, Chemical mechanical polishing) process. When the CMP is used to polish a surface of a hybrid bonding structure, because a polishing rate of an insulation material is different from a polishing rate of a metal material, a bonding interface of the hybrid bonding structure is not absolutely flat. In other words, there is a specific height difference between a surface of a metal solder pad and a surface of an insulation medium. Generally, the polishing rate of the metal material is higher than the polishing rate of the insulation material. In other words, inward depression occurs on the surface of the metal solder pad, and consequently in the bonding interface, the surface of the metal solder pad is lower than the surface of the insulation medium. A larger area of a pattern formed on the surface of the metal solder pad indicates deeper inward depression of the metal solder pad. As shown in FIG. 1C and FIG. 1D, FIG. 1C and FIG. 1D show depths of inward depression of metal solder pads with different surface areas. FIG. 1C is a side view comparison diagram of inward depression of two types of metal solder pads. FIG. 1D is a top view comparison diagram of patterns formed on bonding interfaces by the two types of metal solder pads. An area of a pattern formed on a surface of the metal solder pad 1 is greater than an area of a pattern formed on a surface of the metal solder pad 2. It can be learned from FIG. 1C that a depth of inward depression of the surface of the metal solder pad 1 is greater than a depth of inward depression of the surface of the metal solder pad 2. In addition, on the bonding interface, an edge that is of the metal solder pad 1 and that is in contact with the insulation medium may also be depressed inward. In this way, if the metal solder pad 1 shown in FIG. 1C is used in the hybrid bonding structure, when alignment bonding is performed on metal solder pads, two metal solder pads on which the alignment bonding is performed have a very small contact area or cannot be in contact. In addition, a large hole exists between the two metal solder pads on which the alignment bonding is performed. This reduces a bonding effect. To reduce a depth of the depression of the metal solder pad into the insulation medium, in the hybrid bonding structure, a solder pad with a small pattern area formed on a bonding interface is generally used in the industry. In other words, the metal solder pad a1 and the metal solder pad b1 shown in FIG. 1A are used, so that surfaces used for bonding in the hybrid bonding structure tend to be flat. It can be learned from FIG. 1A that the area of the pattern formed on the bonding interface by the metal solder pad a1 and the area of the pattern formed on the bonding interface by the metal solder pad b1 are both small. When the chip 1 is stacked above the chip 2 through the hybrid bonding structure, alignment needs to be precisely performed on the metal solder pad a1 and the metal solder pad b1. However, during actual production, due to impact of various factors, there may be misalignment between the metal solder pad a1 and the metal solder pad b1, that is, alignment offset occurs on the surface of the metal solder pad a1 and the surface of the metal solder pad b1 shown in FIG. 1A. It can be learned from FIG. 1B that bonding is performed on the edge of the surface of the metal solder pad a1 and an edge of the surface of the metal solder pad b1. In other words, there is a small contact area between the metal solder pad a1 and the metal solder pad b1. Because the chip 1 and the chip 2 are connected through the metal solder pad a1 and the metal solder pad b1, alignment offset between the bonding surfaces of the metal solder pad a1 and the metal solder pad b1 causes a resistance increase or even an open circuit on a completed circuit between the chip 1 and the chip 2. This affects performance of signal transmission between the chip 1 and the chip 2.

According to a chip package structure provided in embodiments of this application, a bonding area between to-be-bonded metal solder pads can be increased while a depth of depression of a surface of a metal solder pad into an insulation medium is reduced, so that performance of signal transmission between packaged chips can be improved.

According to the chip package structure provided in embodiments of this application, a plurality of chips may be stacked and packaged in a same package body. Each chip is connected to another chip in a hybrid bonding manner, to implement signal exchange between the plurality of chips. The chip in embodiments of this application may be a die (Die), or may be a chip formed by simply packaging the die and another chip or component (such as an active component or a passive component). After chips in embodiments of this application are prepared, hybrid bonding structures are generally further disposed on the chips for bonding between the chips. A surface of the hybrid bonding structure generally includes a metal solder pad and an insulation medium that isolates the metal solder pad. The hybrid bonding in embodiments of this application means that alignment bonding is separately performed on metal solder pads and insulation media in bonding interfaces of the hybrid bonding structures. It should be noted that the chip package structure described in embodiments of this application may be a chip package structure obtained by performing hybrid bonding on wafers and then performing wafer cutting, may be a chip package structure obtained by performing hybrid bonding on chips, or may be a chip package structure obtained by performing hybrid bonding on a wafer and a chip. The following describes the chip package structure in embodiments of this application by using an example in which hybrid bonding is performed on chips and two chips are packaged in a same package body.

FIG. 2 is a schematic structural diagram of a chip package structure according to an embodiment of this application. In FIG. 2, the chip package structure 100 includes a chip 10 and a chip 20, and the chip 20 is stacked above the chip 10. Types of the chip 10 and the chip 20 are specifically described above. In addition, the chip package structure 100 further includes a hybrid bonding structure 11 and a hybrid bonding structure 21. The hybrid bonding structure 11 and the hybrid bonding structure 21 are disposed between the chip 10 and the chip 20. The chip 20 is bonded to the chip 10 through the hybrid bonding structure 11 and the hybrid bonding structure 21. It should be noted that the hybrid bonding structure 11 is pre-formed on the chip 10 before bonding. Similarly, the hybrid bonding structure 21 is pre-formed on the chip 20 before bonding. As shown in FIG. 3, FIG. 3 is a schematic diagram of a relative position relationship between the chip 10 and the hybrid bonding structure 11 before bonding. A relative position relationship between the chip 20 and the hybrid bonding structure 21 before bonding may also be shown in FIG. 3. When bonding is performed on the chip 10 and the chip 20, alignment bonding is separately performed on metal solder pads in the hybrid bonding structure 11 and the hybrid bonding structure 21, and insulation materials in the hybrid bonding structure 11 and the hybrid bonding structure 21.

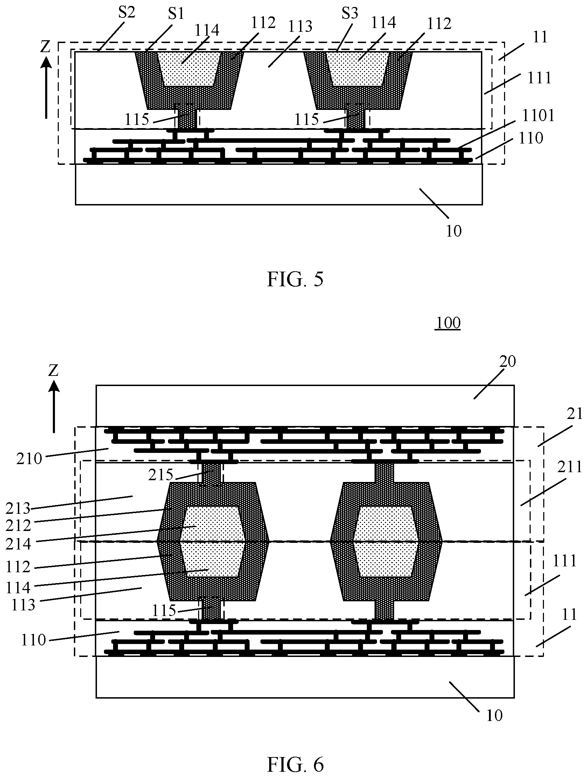

In this embodiment of this application, the hybrid bonding structure 11 and the hybrid bonding structure 21 may be of a same structure. The following uses the hybrid bonding structure 11 as an example to describe in detail the hybrid bonding structure provided in this embodiment of this application. FIG. 4 is a top view of the hybrid bonding structure 11 according to this embodiment of this application, and FIG. 5 is a side view of the hybrid bonding structure 11 in FIG. 4 cut along AA'. As shown in FIG. 5, the hybrid bonding structure 11 includes a redistribution layer 110 and a bonding layer 111. The redistribution layer 110 is closer to a substrate of a chip, and the bonding layer 111 is formed on the redistribution layer. The redistribution layer 110 may include a plurality of layers of patterned conductive lines 1101 and an insulation material that isolates the patterned conductive lines. A conductive material used to form the conductive lines 1101 may be a metal, for example, one or a combination of a plurality of metals such as copper (Cu), silver (Ag), and aluminum (Al). The conductive material used to form the conductive lines may alternatively be tin oxide (ITO), graphite, graphene, or the like. The insulation material may be an inorganic insulation material, an organic insulation material, or the like. A via (Via) may be further disposed on the redistribution layer 110, and the via may include but is not limited to a through via or a buried via. The via may be filled with or electroplated with a conductive material. The bonding layer 111 may include an insulation material 113 formed by at least one of silicon dioxide (SiO2), silicon nitride (SiN), silicon oxynitride (SiON), and silicon carbide (SiC), and a plurality of metal solder pads 112 embedded in the insulation material. A top of the metal solder pad 112 is exposed to a surface of the insulation material. The plurality of metal solder pads 112 are disposed in parallel and spaced apart in the bonding layer 111. Two metal solder pads 112 are schematically shown in FIG. 5. It may be understood that the hybrid bonding structure 11 may include more metal solder pads 112. A quantity of metal solder pads 112 is not specifically limited in this embodiment of this application.

In this embodiment of the present invention, the metal solder pad 112 includes a groove structure. A groove bottom of the groove structure is buried in the insulation material 113. A groove opening is exposed to a surface of the insulation material 113 and is flush with the surface of the insulation material 113. The groove structure is filled with an insulation medium 114. A surface of the insulation medium 114 is flush with the surface of the insulation material 113. Therefore, a surface S1 of the metal solder pad 112, a surface S2 of the insulation material 113, and a surface S3 of the insulation medium 114 are located on a same horizontal plane, that is, form a bonding interface of the hybrid bonding structure 11. The bonding interface is obtained by polishing the surface of the hybrid bonding structure 11 through a chemical mechanical polishing (CMP, Chemical mechanical polishing) process. A material used to form the insulation medium 114 may include at least one of silicon dioxide (SiO2), silicon nitride (SiN), silicon oxynitride (SiON), and silicon carbide (SiC). Further, the bonding layer 111 is further provided with a plurality of vias 115, and the via 115 may be filled with or electroplated with a conductive material. The conductive material may be, for example, a metal material. The via 115 is configured to connect the metal solder pad 112 to a conductive line in the redistribution layer 11.

In this embodiment of this application, the surface of the metal solder pad 112, the surface of the insulation material 113, and the surface of the insulation medium 114 are flush, so that the bonding interface of the bonding layer 111 tends to be flat. This avoids the inward depression of the surface of the metal solder pad 1 shown in FIG. 1C and avoids a hole on the bonding interface when the bonding layer 111 and a bonding layer 112 are bonded. This helps increase a contact area between the metal solder pads on which alignment bonding is performed, and improves a bonding effect.

Based on the hybrid bonding structures shown in FIG. 4 and FIG. 5, refer to FIG. 6. FIG. 6 is a more detailed schematic structural diagram of the chip package structure 100 according to this embodiment of this application. In FIG. 6, bonding is performed on the bonding interface of the hybrid bonding structure 11 and a bonding interface of the hybrid bonding structure 21. In other words, alignment bonding is performed on a surface of an insulation material 213 and the surface of the insulation material 113, on a surface of a metal solder pad 212 and the surface of the metal solder pad 112, and on a surface of an insulation medium 214 and the surface of the insulation medium 114. In addition, the metal solder pad 112 in the hybrid bonding structure 11 is connected to a metal line on the redistribution layer 110 through a corresponding via 115, so that the chip 10 is connected to the metal solder pad 112 through the redistribution layer 110 and the via 115. Similarly, the metal solder pad 212 in the hybrid bonding structure 21 is connected to a metal line on a redistribution layer 210 through a corresponding via 215, so that the chip 20 is connected to the metal solder pad 212 through the redistribution layer 210 and the via 215. Therefore, in the chip package structure 100 shown in FIG. 6, the chip 10 is connected to the chip 20 through an electronic line on the redistribution layer 110, the via 115, the metal solder pad 112, the metal solder pad 212, the via 215, and an electronic line on the redistribution layer 210, to implement signal transmission between the chip 10 and the chip 20.

In this embodiment of this application, a pattern formed on the surface of the metal solder pad 112 is a ring. The ring may include, for example, but is not limited to, one of the following: a triangular ring, a quadrilateral ring, or a polygonal ring. As shown in FIG. 4, a case in which the pattern formed on the surface of the metal solder pad 112 is the quadrilateral ring is schematically shown in FIG. 4.

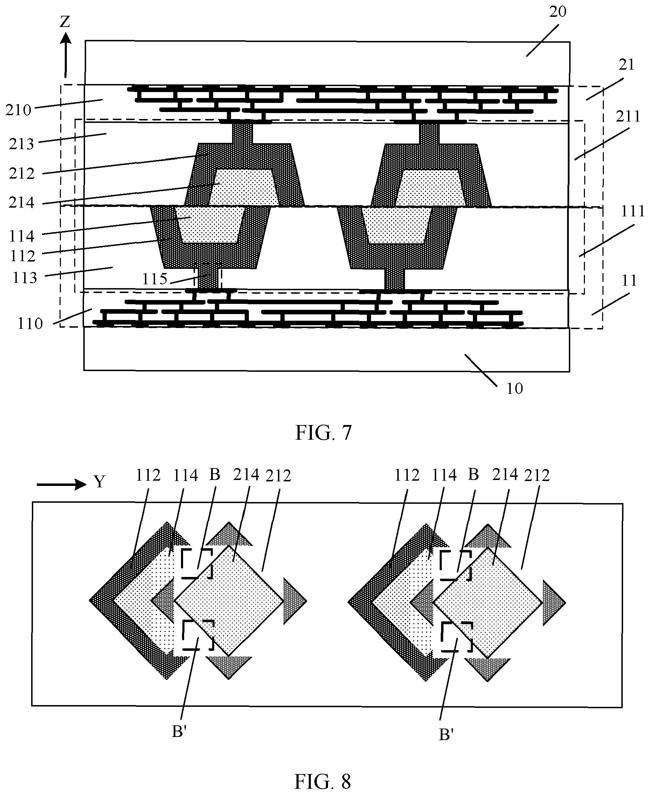

In the chip package structure 100 shown in FIG. 6, alignment bonding performed on the surface of the metal solder pad 212 and the surface of the metal solder pad 112 is an ideal case. During actual production, due to impact of various factors, alignment offset may occur between the bonding interface of the bonding layer 111 and the bonding interface of the bonding layer 211. Consequently, offset may occur when the surface of the metal solder pad 212 and the surface of the metal solder pad 112 are bonded. As shown in FIG. 7, FIG. 7 is a schematic structural diagram of a chip package structure 100 in which relative position offset occurs when the surface of the metal solder pad 212 and the surface of the metal solder pad 112 are bonded. FIG. 8 is a top view of a bonding interface of the chip package structure 100 shown in FIG. 7. When offset occurs between the surface of the metal solder pad 212 and the surface of the metal solder pad 112, as shown in FIG. 7 and FIG. 8, in addition to overlapping with the metal solder pad 112, the metal solder pad 212 partially overlaps with the insulation medium 114 and the insulation material 113. Similarly, in addition to overlapping with the metal solder pad 212, the metal solder pad 112 partially overlaps with the insulation medium 214 and the insulation material 213. It should be noted that, during a bonding process, bonding is performed on an overlapping part between the metal solder pad 212 and the metal solder pad 112, both the overlapping part between the metal solder pad 212 and each of the insulation medium 114 and the insulation material 113, and the overlapping part between the metal solder pad 112 and each of the insulation medium 214 and the insulation material 213 are not bonded. It can be learned from FIG. 8 that when the offset occurs between the surface of the metal solder pad 212 and the surface of the metal solder pad 112 in a direction Y, overlapping regions B and B' exist between the surface of the metal solder pad 212 and the surface of the metal solder pad 112. Even if an offset between the surface of the metal solder pad 212 and the surface of the metal solder pad 112 in the direction Y is large, the overlapping regions B and B' still exist between the surface of the metal solder pad 212 and the surface of the metal solder pad 112.

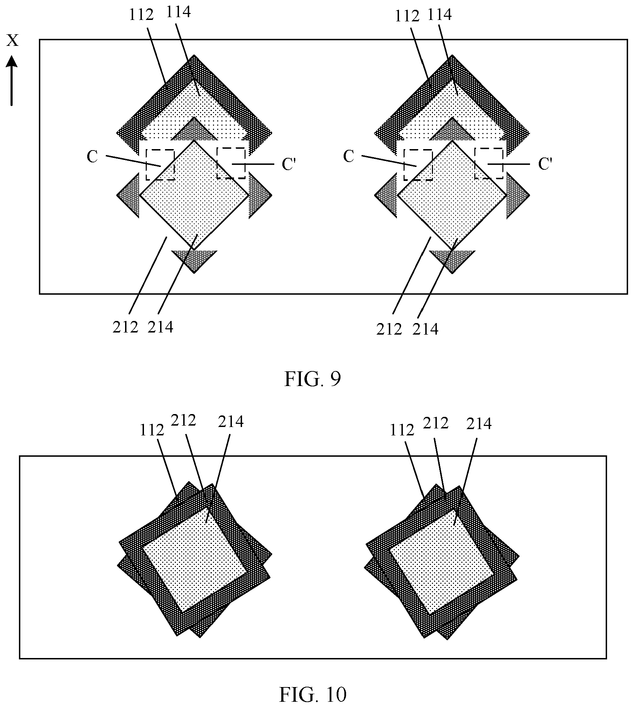

FIG. 8 shows a case in which alignment offset occurs between the surface of the metal solder pad 212 and the surface of the metal solder pad 112 in a direction Y Further, the alignment offset may occur between the surface of the metal solder pad 212 and the surface of the metal solder pad 112 in a direction Z. FIG. 9 shows a case in which the alignment offset occurs between the surface of the metal solder pad 212 and the surface of the metal solder pad 112 in the direction Z It can be learned from FIG. 9 that when the alignment offset occurs between the surface of the metal solder pad 212 and the surface of the metal solder pad 112 in the direction Z, overlapping regions C and C' still exist between the surface of the metal solder pad 212 and the surface of the metal solder pad 112. In addition, as shown in FIG. 10, rotation offset may occur between the surface of the metal solder pad 212 and the surface of the metal solder pad 112. It can be learned from FIG. 10 that when the rotation offset occurs between the surface of the metal solder pad 212 and the surface of the metal solder pad 112, a large overlapping region still exists between the surface of the metal solder pad 212 and the surface of the metal solder pad 112.

It can be learned from FIG. 8 to FIG. 10 that in this embodiment of this application, a pattern formed on a surface of a metal solder pad in a hybrid bonding structure is set to be a ring, so that when the hybrid bonding structure 11 and the hybrid bonding structure 21 are bonded, regardless of how a relative position between the surface of the metal solder pad 112 and the surface of the metal solder pad 212 is offset, a large overlapping area exists between the surface of the metal solder pad 112 and the surface of the metal solder pad 212. In addition, because the pattern formed on the surface of the metal solder pad is a ring, a depth of depression of the metal solder pad 112 into the bonding layer 111 may be reduced by reducing a width between an inner ring and an outer ring of the metal solder pad. Therefore, in this embodiment of this application, a pattern of a to-be-bonded surface of a metal solder pad is set to be a ring, so that a bonding area between the surface of the metal solder pad 112 and the surface of the metal solder pad 212 can be increased when depths of depression of the surface of the metal solder pad 112 and the surface of the metal solder pad 212 into a bonding layer are reduced. This improves performance of signal transmission between packaged chips.

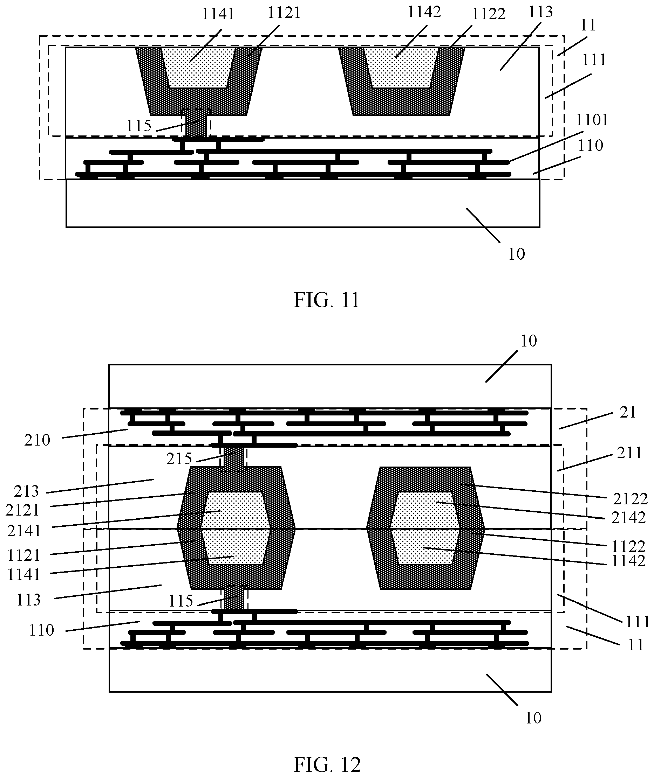

In the hybrid bonding structure shown in FIG. 5 to FIG. 7, each metal solder pad in the hybrid bonding structure is connected to the redistribution layer through the via. In some other scenarios, for example, when there are a small quantity of leading-out ends of the chip 10 and the chip 20, a small quantity of metal solder pads may be disposed in the hybrid bonding structure to implement connection between the chip 10 and the chip 20. In this case, a proportion of surface areas of the small quantity of metal solder pads in the bonding interface is excessively small. To improve flatness and uniformity of the bonding interface after the CMP, more metal solder pads may need to be disposed in the bonding layer to increase a proportion of metal in the bonding interface. Based on this, in a possible implementation of this embodiment of this application, in addition to the metal solder pad connected to the redistribution layer through the via, a metal solder pad that is not connected to the via is further disposed in the hybrid bonding structure 11. As shown in FIG. 11, FIG. 11 is still another schematic structural diagram of the hybrid bonding structure 11 according to an embodiment of this application. In FIG. 11, the hybrid bonding structure 11 includes a metal solder pad 1121 and a metal solder pad 1122. The metal solder pad 1121 is connected to an electronic line 1101 on the redistribution layer 110 through a via 1151, and the metal solder pad 1122 is insulated from the electronic line 1101 on the redistribution layer 110. A structure of the metal solder pad 1121 and a structure of the metal solder pad 1122 are the same as the structure of the metal solder pad 112 shown in FIG. 5, and details are not described herein again. In addition, the metal solder pad 1121 is filled with an insulation medium 1141, and the metal solder pad 1122 is filled with an insulation medium 1142. A structure of the redistribution layer 110 is the same as the structure of the redistribution layer 110 shown in FIG. 5, and details are not described again.

Based on the hybrid bonding structure shown in FIG. 11, refer to FIG. 12. FIG. 12 is still another schematic structural diagram of the chip package structure 100 according to an embodiment of this application. In FIG. 12, alignment bonding is performed on a surface of an insulation material 2131 and a surface of an insulation material 1131, on a surface of a metal solder pad 2121 and a surface of a metal solder pad 1121, on a surface of a metal solder pad 2122 and a surface of a metal solder pad 1122, on a surface of an insulation medium 2141 and a surface of the insulation medium 1141, and on a surface of an insulation medium 2142 and a surface of an insulation medium 1142. In addition, the metal solder pad 1121 in the hybrid bonding structure 11 is connected to the conductive line on the redistribution layer 110 through the via 115, so that the chip 10 is connected to the metal solder pad 1121 through the redistribution layer 110 and the via 115. The metal solder pad 2121 in the hybrid bonding structure 21 is connected to the metal line on the redistribution layer 210 through the via 215, so that the chip 20 is connected to the metal solder pad 2121 through the redistribution layer 210 and the via 115. Therefore, in the chip package structure 100 shown in FIG. 12, the chip 10 is connected to the chip 20 through the conductive line on the redistribution layer 110, the via 115, the metal solder pad 1121, the metal solder pad 2121, the via 215, and the conductive line on the redistribution layer 210, to implement signal transmission between the chip 10 and the chip 20.

It should be noted that based on the package structure 100 shown in FIG. 11, when the surface of the metal solder pad 2121 and the surface of the metal solder pad 1121 are bonded, offset may occur on a relative position between the surface of the metal solder pad 2121 and the surface of the metal solder pad 1121. After the offset occurs, the relative position between the surface of the metal solder pad 2121 and the surface of the metal solder pad 1121 is shown in FIG. 8 to FIG. 10, and details are not described again.

In the chip package structure 100 described above in embodiments of this application, one chip is stacked above the chip 10. In another possible implementation, more chips may be stacked above the chip 10 in sequence, and the chips may be connected to each other through the hybrid bonding structure shown in FIG. 5 or FIG. 11.

An embodiment of this application further includes an electronic device. The electronic device includes the chip package structure 100 shown in the foregoing embodiments. The chip packaged in the chip package structure 100 may include but is not limited to: a system-on-a-chip (system-on-a-chip), a memory (Memory), a discrete device, an application processor (Application Processor, AP) chip, a micro-electro-mechanical system (Micro-Electro-Mechanical System, MEMS), a microwave radio frequency chip, an application-specific integrated circuit (Application-Specific Integrated Circuit, ASIC for short), and the like. During specific application, the application processor chip or the application-specific integrated circuit may be a central processing unit (Central Processing Unit, CPU), a graphics processing unit (Graphics Processing Unit, GPU), or an artificial intelligence processor, for example, a neural-network processing unit (Neural-Network Processing Unit, NPU). The memory may be a cache (cache), a random access memory (Random Access Memory, RAM), a read-only memory (Read-Only Memory, ROM), or another memory. The discrete device may include, for example, but is not limited to, a field-effect transistor, a bipolar transistor, and an integrated operational amplifier. For example, when a fan-out package structure shown in FIG. 6 is used, the chip 10 and the chip 11 packaged in the fan-out package structure may be respectively an application processor chip and a discrete device. For another example, when the chip package structure 100 shown in FIG. 5 is used, the chip 10 and the chip 20 packaged in the chip package structure 100 may be respectively an application processor chip and a memory. In addition, the electronic device may alternatively be an integrated circuit product. In addition to the chip package structure 100 in this embodiment of this application, the integrated circuit product may further include another integrated circuit, so that the chip package structure 100 shown in this embodiment of this application cooperates with the another integrated circuit to implement various circuit functions.

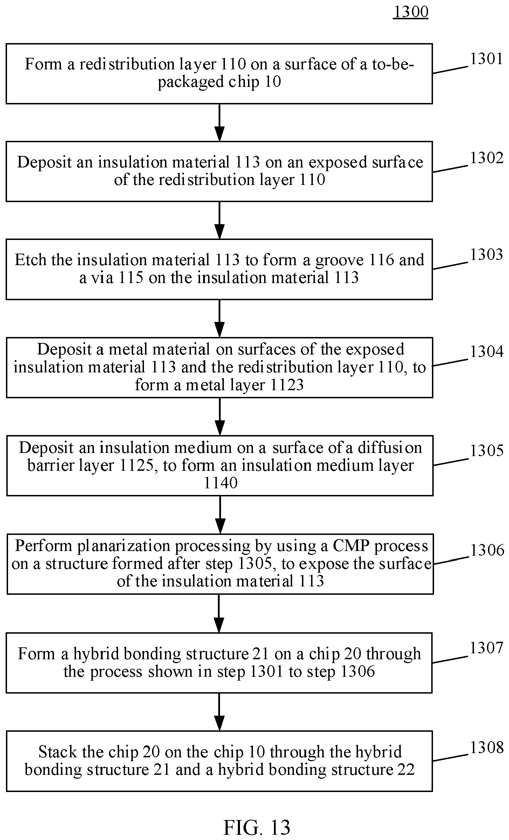

Based on the chip package structure 100 described in the foregoing embodiments, an embodiment of this application further provides a method for the chip package structure 100. With reference to a technological process 1300 shown in FIG. 13, the following uses a structure of the prepared chip package structure 100 shown in FIG. 11 as an example to describe in detail a technological process of preparing the chip package structure 100. The technological process 1300 includes the following steps.

Step 1301: Form a redistribution layer 110 on a surface of a to-be-packaged chip 10.

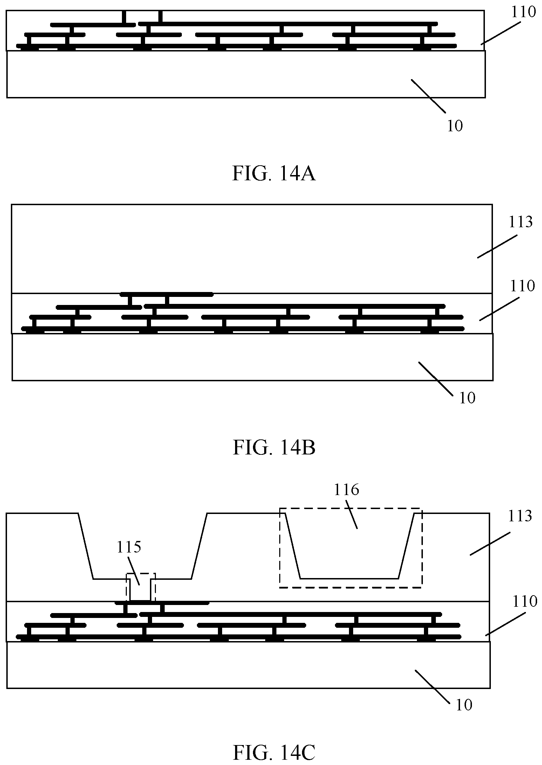

In this step, a standard process such as photoetching, development, and etching may be used to prepare the redistribution layer 110 on the surface of the chip 10. The redistribution layer 110 includes a plurality of wiring layers, and each wiring layer includes a patterned conductive line. The wiring layers are connected through vias. In addition, a leading-out end of the chip 10 is connected to a conductive line on the redistribution layer 110. A structure formed after this step is shown in FIG. 14A.

Step 1302: Deposit an insulation material 113 on an exposed surface of the redistribution layer 110.

In a specific process, a vapor deposition (for example, physical vapor deposition or chemical vapor deposition) method may be used to deposit the insulation material on the surface of the chip 10. A structure formed after this step is shown in FIG. 14B.

Step 1303: Etch the insulation material 113 to form a groove 116 and a via 115 on the insulation material 113.

In this step, a photoresist may be first deposited on a surface of the insulation material 113. Then, a mask plate is used to etch a part that is in the insulation material 113 and that is not covered by the mask plate. In a process of etching the insulation material 113, a plurality of grooves 116 may be first etched on the insulation material 113. Then, some grooves 116 are further etched to form a via 115. A structure formed after this step is shown in FIG. 14C. The insulation material 113 may be etched by using a dry etching method or a wet etching method.

Step 1304: Deposit a metal material on surfaces of the exposed insulation material 113 and the redistribution layer 110, to form a metal layer 1123.

First, a material used to block metal diffusion is deposited on the exposed surfaces of the insulation material 113 and the redistribution layer 110, to form a barrier layer 1124 on the exposed surfaces of the insulation material 113 and the redistribution layer 110. An etching speed of the barrier layer 1124 is slower than an etching speed of the metal material. A material used to form the barrier layer 1124 includes but is not limited to: titanium (Ti), tantalum (Ta), titanium nitride (TiN), or tantalum nitride (TaN). In a specific process, the barrier layer 1124 may be formed by using a physical vapor deposition method.

Then, a metal material is deposited on the barrier layer 1124, to form the metal layer 1123. In a specific process, the metal material may be deposited on the surface of the barrier layer 1124 by using a physical vapor deposition and electroplating method. The metal material may include but is not limited to a material such as copper, aluminum, silver, or gold, or an alloy material of metal.

Then, a material used to block metal diffusion is deposited on the metal layer 1123, to form a barrier layer 1125. The material used to form the barrier layer 1125 includes but is not limited to: titanium (Ti), tantalum (Ta), titanium nitride (TiN), or tantalum nitride (TaN). In a specific process, the barrier layer 1125 may be formed by using a physical vapor deposition method.

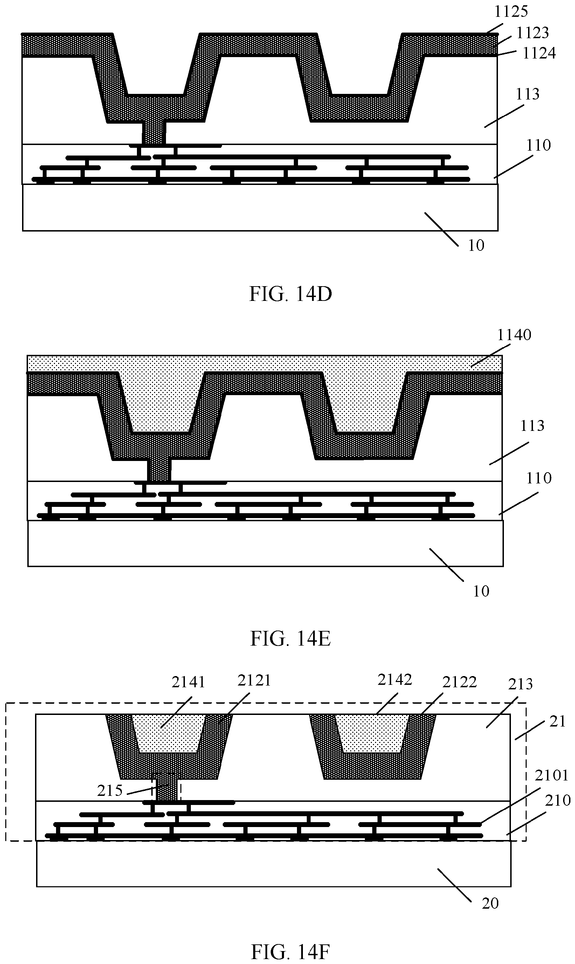

After step 1304, a structure formed is shown in FIG. 14D.

Step 1305: Deposit an insulation medium on a surface of the diffusion barrier layer 1125, to form an insulation medium layer 1140, as shown in FIG. 14E.

Step 1306: Perform planarization processing by using a CMP process on the structure formed after step 1305, to expose the surface of the insulation material 113.

After this step, a metal solder pad 1121 and a metal solder pad 1122 are formed. The metal solder pad 1121 and the metal solder pad 1122 are respectively filled with an insulation medium 1141 and an insulation medium 1142. In addition, the surface of the insulation layer 113, a surface of the metal solder pad 1121, a surface of the metal solder pad 1122, a surface of the insulation medium 1141, and a surface of the insulation medium 1142 are flush.

After step 1302 to step 1306, a bonding layer 111 is formed on the redistribution layer 10.

After step 1301 to step 1306, a hybrid bonding structure 11 is formed on the chip 10, as shown in FIG. 11.

Step 1307: Form a hybrid bonding structure 21 on a chip 20 through the process shown in step 1301 to step 1306.

FIG. 14F is a schematic structural diagram of the hybrid bonding structure 21 formed on the chip 20.

Step 1308: Stack the chip 20 on the chip 10 through the hybrid bonding structure 21 and the hybrid bonding structure 22.

Specifically, alignment bonding is performed on a surface of an insulation material 213 and the surface of the insulation material 113, on a surface of a metal solder pad 2121 and the surface of the metal solder pad 1121, on a surface of a metal solder pad 2122 and the surface of the metal solder pad 1122, on a surface of an insulation medium 2141 and the surface of the insulation medium 1141, and on a surface of an insulation medium 2142 and the surface of the insulation medium 1142. The chip 10 is connected to the chip 20 through an electronic line on the redistribution layer 110, the via 115, the metal solder pad 1121, the metal solder pad 2121, a via 215, and an electronic line on a redistribution layer 210, to implement signal transmission between the chip 10 and the chip 20.

After step 1301 to step 1308, the chip package structure 100 shown in FIG. 12 may be formed.

Finally, it should be noted that the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. A chip package structure, comprising a first chip and a first hybrid bonding structure, wherein the first chip is connected to another chip through the first hybrid bonding structure;
the first hybrid bonding structure comprises a first bonding layer, the first bonding layer is disposed on a side away from a substrate of the first chip, and the first bonding layer comprises a first insulation material and a plurality of first metal solder pads embedded in the first insulation material;
each of the plurality of first metal solder pads comprises a groove structure, a groove bottom of the groove structure is buried in the first insulation material, and a groove opening of the groove structure is exposed to a surface of the first insulation material and is flush with the surface of the first insulation material; and
the groove structure is filled with a first insulation medium, and a surface of the first insulation medium is flush with the surface of the first insulation material.

2. The chip package structure according to claim 1, wherein a plurality of vias are further disposed in the first bonding layer;
each of the plurality of vias is filled with or electroplated with a conductive material; and
at least a part of the plurality of first metal solder pads are connected to the first chip through a corresponding via.

3. The chip package structure according to claim 2, wherein the first hybrid bonding structure further comprises a first redistribution layer;
the first redistribution layer is formed between the first chip and the bonding layer;
the first redistribution layer comprises a plurality of layers of patterned conductive lines; and
the at least a part of the plurality of first metal solder pads are connected to the first chip through the plurality of vias and the conductive lines.

4. The chip package structure according to any one of claims 1 to 3, wherein a pattern formed on a surface of each of the plurality of first metal solder pads is a ring.

5. The chip package structure according to any one of claims 1 to 4, further comprising a second chip and a second hybrid bonding structure, wherein
the second chip is stacked above the first chip; and
the second chip is connected to the first chip through the first hybrid bonding structure and the second hybrid bonding structure.

6. The chip package structure according to claim 5, wherein the second hybrid bonding structure comprises a second bonding layer, and the second bonding layer is disposed on a side away from a substrate of the second chip;
the second bonding layer comprises a second insulation material and a plurality of second metal solder pads embedded in the second insulation material;
each of the plurality of second metal solder pads comprises the groove structure, a groove bottom of the groove structure is buried in the second insulation material, and a groove opening of the groove structure is exposed to a surface of the second insulation material and is flush with the surface of the second insulation material; and
the groove structure is filled with a second insulation medium, and a surface of the second insulation medium is flush with the surface of the second insulation material.

7. The chip package structure according to claim 6, wherein the first metal solder pads are configured to be correspondingly bonded to the second metal solder pads, the first insulation material is configured to be correspondingly bonded to the second insulation material, and the first insulation medium is configured to be correspondingly bonded to the second insulation medium.

8. The chip package structure according to claim 6 or 7, wherein a pattern formed on a surface of each of the plurality of second metal solder pads is a ring.

9. A method for preparing a chip package structure, comprising:
forming a first insulation material on an active surface of a first chip;
etching the first insulation material to form a plurality of grooves;
depositing a metal material on a surface of the first insulation material, wherein the metal material forms a groove structure in the grooves;
depositing a first insulation medium on a surface of the metal material; and
performing planarization processing on the first insulation medium, the metal material, and the first insulation material through a polishing process, to form a first bonding layer, wherein
the first bonding layer comprises a plurality of first metal solder pads, each of the plurality of first metal solder pads comprises the groove structure, a groove opening of the groove structure is exposed to the surface of the first insulation material and is flush with the surface of the first insulation material, and a surface of the first insulation medium is flush with the surface of the insulation material.

10. The method according to claim 9, wherein the forming a first insulation material on an active surface of the first chip comprises:
forming a redistribution layer on the active surface of the first chip, wherein the redistribution layer comprises a plurality of layers of patterned conductive lines; and
forming the first insulation material on the redistribution layer.

11. The method according to claim 10, wherein after the etching the first insulation material to form a plurality of grooves, the method further comprises:
further etching a bottom of at least a part of the plurality of grooves, to form a via that connects the bottom of the groove and the conductive line on the redistribution layer.

12. The method according to claim 11, wherein the method further comprises:
forming a second bonding layer on an active surface of a second chip, wherein
the second bonding layer comprises a second insulation material and a plurality of second metal solder pads embedded in the second insulation material;
each of the plurality of second metal solder pads comprises the groove structure, a groove bottom of the groove structure is buried in the second insulation material, and a groove opening of the groove structure is exposed to a surface of the second insulation material and is flush with the surface of the second insulation material; and
the groove structure is filled with a second insulation medium, and a surface of the second insulation medium is flush with the surface of the second insulation material.

13. The method according to claim 12, wherein the method further comprises:
bonding the plurality of first metal solder pads to the plurality of second metal solder pads, the first insulation material to the second insulation material, and the first insulation medium to the second insulation medium through a same bonding process.
